(19) Europäisches Patentamt
European Patent Office
Office européen des brevets

(11) **EP 1 941 549 B1**

(12) **EUROPEAN PATENT SPECIFICATION**

(45) Date of publication and mention of the grant of the patent:
**02.05.2018 Bulletin 2018/18**

(51) Int Cl.:
*H01L 29/78* (2006.01)   *H01L 29/15* (2006.01)
*H01L 29/10* (2006.01)   *H01L 29/08* (2006.01)

(21) Application number: **06815262.8**

(22) Date of filing: **22.09.2006**

(86) International application number:
**PCT/US2006/037140**

(87) International publication number:
**WO 2007/038365 (05.04.2007 Gazette 2007/14)**

(54) **SEMICONDUCTOR DEVICE INCLUDING REGIONS OF BAND-ENGINEERED SEMICONDUCTOR SUPERLATTICE TO REDUCE DEVICE ON-RESISTANCE AND ASSOCIATED METHODS**

HALBLEITERANORDNUNG MIT REGIONEN AUS EINEM BANDANGEPASSTEN HALBLEITER-SUPERGITTER ZUR VERRINGERUNG DES EIN-WIDERSTANDS DER ANORDNUNG UND ENTSPRECHENDE VERFAHREN

DISPOSITIF A SEMI-CONDUCTEURS COMPRENANT DES REGIONS A SUPER-RESEAUX DE SEMI-CONDUCTEURS A INGENIERIE DE BANDE DESTINEES A REDUIRE LA RESISTANCE A L'ETAT PASSANT DU DISPOSITIF ET PROCEDES DE FABRICATION CORRESPONDANTS

(84) Designated Contracting States:
**DE FR GB IT**

(30) Priority: **23.09.2005 US 720302 P**

(43) Date of publication of application:
**09.07.2008 Bulletin 2008/28**

(73) Proprietor: **Mears Technologies, Inc.**
**Waltham, MA 02451 (US)**

(72) Inventor: **BLANCHARD, Richard A.**
**Los Altos California 92024 (US)**

(74) Representative: **Zambardino, Umberto et al**
**Botti & Ferrari S.r.l.**
**Via Cappellini, 11**
**20124 Milano (IT)**

(56) References cited:
**WO-A-2005/034245     US-A- 5 357 119**

**Description**

**Field of the Invention**

The present invention relates to the field of semiconductors, and, more particularly, to semiconductors having enhanced properties based upon energy band engineering and associated methods.

**Background of the Invention**

Structures and techniques have been proposed to enhance the performance of semiconductor devices, such as by enhancing the mobility of the charge carriers. For example, U.S. Patent Application No. 2003/0057416 to Currie et al. discloses strained material layers of silicon, silicon-germanium, and relaxed silicon and also including impurity-free zones that would otherwise cause performance degradation. The resulting biaxial strain in the upper silicon layer alters the carrier mobilities enabling higher speed and/or lower power devices. Published U.S. Patent Application No. 2003/0034529 to Fitzgerald et al. discloses a CMOS inverter also based upon similar strained silicon technology.

U.S. Patent No. 6,472,685 B2 to Takagi discloses a semiconductor device including a silicon and carbon layer sandwiched between silicon layers so that the conduction band and valence band of the second silicon layer receive a tensile strain. Electrons having a smaller effective mass, and which have been induced by an electric field applied to the gate electrode, are confined in the second silicon layer, thus, an n-channel MOSFET is asserted to have a higher mobility.

U.S. Patent No. 4,937,204 to Ishibashi et al. discloses a superlattice in which a plurality of layers, less than eight monolayers, and containing a fractional or binary or a binary compound semiconductor layer, are alternately and epitaxially grown. The direction of main current flow is perpendicular to the layers of the superlattice.

U.S. Patent No. 5,357,119 to Wang et al. discloses a Si-Ge short period superlattice with higher mobility achieved by reducing alloy scattering in the superlattice. Along these lines, U.S. Patent No. 5,683,934 to Candelaria discloses an enhanced mobility MOSFET including a channel layer comprising an alloy of silicon and a second material substitutionally present in the silicon lattice at a percentage that places the channel layer under tensile stress.

U.S. Patent No. 5,216,262 to Tsu discloses a quantum well structure comprising two barrier regions and a thin epitaxially grown semiconductor layer sandwiched between the barriers. Each barrier region consists of alternate layers of SiO2/Si with a thickness generally in a range of two to six monolayers. A much thicker section of silicon is sandwiched between the barriers.

An article entitled "Phenomena in silicon nanostructure devices" also to Tsu and published online September 6, 2000 by Applied Physics and Materials Science & Processing, pp. 391-402 discloses a semiconductor-atomic superlattice (SAS) of silicon and oxygen. The Si/O superlattice is disclosed as useful in a silicon quantum and light-emitting devices. In particular, a green electromuminescence diode structure was constructed and tested. Current flow in the diode structure is vertical, that is, perpendicular to the layers of the SAS. The disclosed SAS may include semiconductor layers separated by adsorbed species such as oxygen atoms, and CO molecules. The silicon growth beyond the adsorbed monolayer of oxygen is described as epitaxial with a fairly low defect density. One SAS structure included a 1.1 nm thick silicon portion that is about eight atomic layers of silicon, and another structure had twice this thickness of silicon. An article to Luo et al. entitled "Chemical Design of Direct-Gap Light-Emitting Silicon" published in Physical Review Letters, Vol. 89, No. 7 (August 12, 2002) further discusses the light emitting SAS structures of Tsu.

Published International Application WO 02/103,767 A1 to Wang, Tsu and Lofgren, discloses a barrier building block of thin silicon and oxygen, carbon, nitrogen, phosphorous, antimony, arsenic or hydrogen to thereby reduce current flowing vertically through the lattice more than four orders of magnitude. The insulating layer/barrier layer allows for low defect epitaxial silicon to be deposited next to the insulating layer.

Published Great Britain Patent Application 2,347,520 to Mears et al. discloses that principles of Aperiodic Photonic Band-Gap (APBG) structures may be adapted for electronic bandgap engineering. In particular, the application discloses that material parameters, for example, the location of band minima, effective mass, etc, can be tailored to yield new aperiodic materials with desirable band-structure characteristics. Other parameters, such as electrical conductivity, thermal conductivity and dielectric permittivity or magnetic permeability are disclosed as also possible to be designed into the material. Document WO 2005/034245 is directed to a semiconductor device which includes a superlattice that, in turn, includes a plurality of stacked groups of layers. The device also includes regions for causing transport of charge carriers through the superlattice in a parallel direction relative to the stacked groups of layers. Each group of the superlattice includes a plurality of stacked base semiconductor monolayers defining a base semiconductor portion and an energy band-modifying layer thereon. Moreover, the energy-band modifying layer includes at least one non-semiconductor monolayer constrained within a crystal lattice of adjacent base semiconductor portions. Accordingly, the superlattice has a higher charge carrier mobility in the parallel direction than would otherwise be present.

The resistance to carrier flow in semiconductor devices is a significant source of inefficiency, particularly in majority carrier devices such as metal-oxide semiconductor field-effect transistors (MOSFETs). Accordingly, it would be desirable to provide enhanced semiconductor materials that could reduce carrier flow on-resistance in such devices.

## Summary of the Invention

In view of the foregoing background, it is therefore an object of the present invention to provide a semiconductor device with reduced carrier flow on-resistance.

This and other objects, features, and advantages in accordance with the invention are provided by a semiconductor device according to claim 1 and by the corresponding manufacturing method according to claim 10. Advantageous embodiments of the invention are set out in the dependent claims.

More particularly, the source and drain regions may be laterally spaced apart, and the spaced apart superlattices may extend laterally between the source and drain regions. Additionally, the source and drain regions may be vertically spaced apart, and the spaced apart superlattices may extend vertically between the source and drain regions. Furthermore, the spaced apart superlattices may be substantially parallel to one another. The device may further include a gate dielectric layer adjacent the channel region, and a gate electrode layer adjacent the gate dielectric layer.

By way of example, the base semiconductor portions may include silicon, and the non-semiconductor monolayers may include oxygen. More generally, the base semiconductor portions may include a base semiconductor selected from the group consisting of Group IV semiconductors, Group III-V semiconductors, and Group II-VI semiconductors, and the non-semiconductor monolayers may include a non-semiconductor selected from the group consisting of oxygen, nitrogen, fluorine, and carbon-oxygen.

Each non-semiconductor layer may be a single monolayer thick, for example. Moreover, each base semiconductor portion may be less than eight monolayers thick. Also, each superlattice may further include a base semiconductor cap layer on an uppermost group of layers. In addition, all of the base semiconductor portions may be a same number of monolayers thick, at least some of the base semiconductor portions may be a different number of monolayers thick, or all of the base semiconductor portions may be a different number of monolayers thick. Furthermore, opposing base semiconductor portions in adjacent groups of layers of each superlattice may be chemically bound together.

Other aspects of the invention relate to associated methods of making the devices.

## Brief Description of the Drawings

FIG. 1 is a top view of a n-channel lateral DMOS device in accordance with the invention including a plurality of superlattices in the drain and channel regions thereof.

FIG. 2 is a cross-sectional view of a superlattice of the device of FIG. 1.

FIG. 3 is a cross-sectional view of the device of FIG. 1 taken along line 3-3.

FIG. 4 is a perspective view of the substrate of the device of FIG. 1 illustrating the superlattice filled trenches therein.

FIG. 5 is a top view of a n-channel vertical DMOS device in accordance with the invention including a plurality of superlattices in the drain and channel regions thereof.

FIG. 6 is a cross-sectional view of a superlattice of the device of FIG. 5.

FIG. 7 is a cross-sectional view of the device of FIG. 5 taken along line 7-7.

FIG. 8 is a perspective view of the substrate of the device of FIG. 5 illustrating the superlattice-filled trenches therein.

FIG. 9 is a greatly enlarged schematic cross-sectional view of a superlattice for use in a semiconductor device in accordance with the present invention.

FIG. 10 is a perspective schematic atomic diagram of a portion of the superlattice shown in FIG. 9.

FIG. 11 is a greatly enlarged schematic cross-sectional view of another embodiment of a superlattice that may be used in the device of FIG. 1.

FIG. 12A is a graph of the calculated band structure from the gamma point (G) for both bulk silicon as in the prior art, and for the 4/1 Si/O superlattice as shown in FIGS. 9-10.

FIG. 12B is a graph of the calculated band structure from the Z point for both bulk silicon as in the prior art, and for the 4/1 Si/O superlattice as shown in FIGS. 9-10.

FIG. 12C is a graph of the calculated band structure from both the gamma and Z points for both bulk silicon as in the prior art, and for the 5/1/3/1 Si/O superlattice as shown in FIG. 11.

FIG. 13 is a cross-sectional view of an n-channel MOSFET device including a plurality of superlattices for reducing on-resistance, according to an example useful for understanding the invention.

FIG. 14 is a cross-section view of an n-channel trench DMOS device in accordance with the invention including a plurality of superlattices for reducing on-resistance.

FIG. 15 is a perspective view of an n-channel super 3D MOSFET in which a plurality of superlattices may be used for reducing on-resistance in accordance with the invention.

## Detailed Description of the Invention

The present invention will now be described more fully hereinafter with reference to the accompanying drawings, in which preferred embodiments of the invention are shown. Rather, these embodiments are provided so that this disclosure will be thorough and complete, and will fully convey the scope of the invention to those skilled in the art. Like numbers refer to like elements throughout, and prime notation is used to indicate similar elements in alternative embodiments.

The present invention relates to controlling the properties of semiconductor materials at the atomic or molecular level to achieve improved performance within semiconductor devices. Further, the invention relates to the identification, creation, and use of improved materials for use in semiconductor devices. In particular, the following description discusses the incorporation of trenches that have been filled with high carrier mobility, band-engineered semiconductor superlattice structures to advantageously reduce device on-resistance.

Applicants theorize, without wishing to be bound thereto, that certain superlattices as described herein reduce the effective mass of charge carriers and that this thereby leads to higher charge carrier mobility. Effective mass is described with various definitions in the literature. As a measure of the improvement in effective mass Applicants use a "conductivity reciprocal effective mass tensor", $\mathbf{M}_e^{-1}$ and $\mathbf{M}_h^{-1}$ for electrons and holes respectively, defined as:

$$\mathbf{M}_{e,ij}^{-1}(E_F,T) = \frac{\sum\limits_{E>E_F}\int\limits_{B.Z.}(\nabla_{\mathbf{k}}E(\mathbf{k},n))_i\,(\nabla_{\mathbf{k}}E(\mathbf{k},n))_j\,\dfrac{\partial f(E(\mathbf{k},n),E_F,T)}{\partial E}\,d^3\mathbf{k}}{\sum\limits_{E>E_F}\int\limits_{B.Z.}f(E(\mathbf{k},n),E_F,T)\,d^3\mathbf{k}}$$

for electrons and:

$$\mathbf{M}_{h,ij}^{-1}(E_F,T) = \frac{-\sum\limits_{E<E_F}\int\limits_{B.Z.}(\nabla_{\mathbf{k}}E(\mathbf{k},n))_i\,(\nabla_{\mathbf{k}}E(\mathbf{k},n))_j\,\dfrac{\partial f(E(\mathbf{k},n),E_F,T)}{\partial E}\,d^3\mathbf{k}}{\sum\limits_{E<E_F}\int\limits_{B.Z.}(1-f(E(\mathbf{k},n),E_F,T))\,d^3\mathbf{k}}$$

for holes, where f is the Fermi-Dirac distribution, $E_F$ is the Fermi energy, T is the temperature, E(k,n) is the energy of an electron in the state corresponding to wave vector k and the $n^{th}$ energy band, the indices i and j refer to Cartesian coordinates x, y and z, the integrals are taken over the Brillouin zone (B.Z.), and the summations are taken over bands with energies above and below the Fermi energy for electrons and holes respectively.

Applicants' definition of the conductivity reciprocal effective mass tensor is such that a tensorial component of the conductivity of the material is greater for greater values of the corresponding component of the conductivity reciprocal effective mass tensor. Again Applicants theorize without wishing to be bound thereto that the superlattices described herein set the values of the conductivity reciprocal effective mass tensor so as to enhance the conductive properties of the material, such as typically for a preferred direction of charge carrier transport. The inverse of the appropriate tensor element is referred to as the conductivity effective mass. In other words, to characterize semiconductor material structures, the conductivity effective mass for conduction electrons and holes as described above and calculated in the direction of intended carrier transport is used to distinguish improved materials.

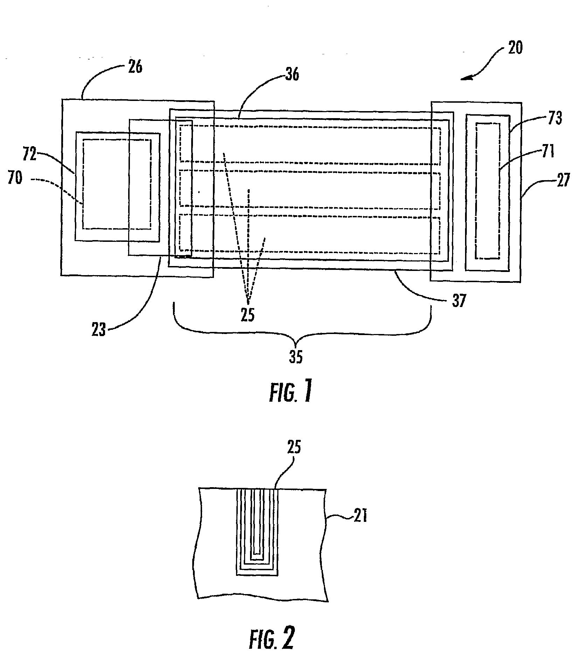

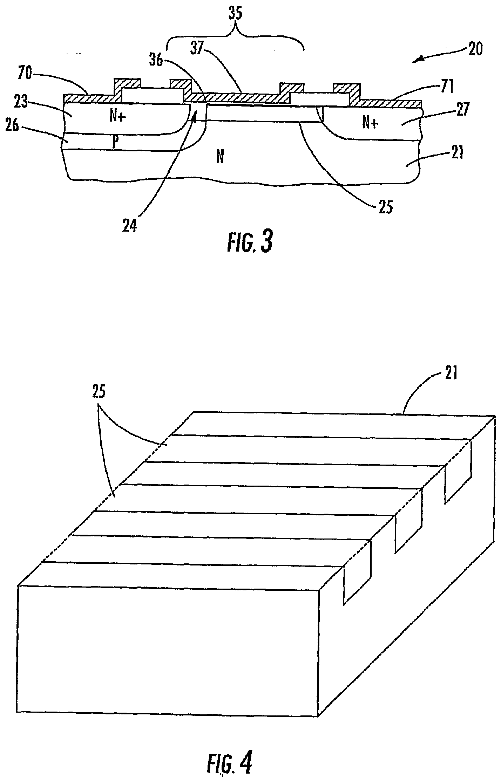

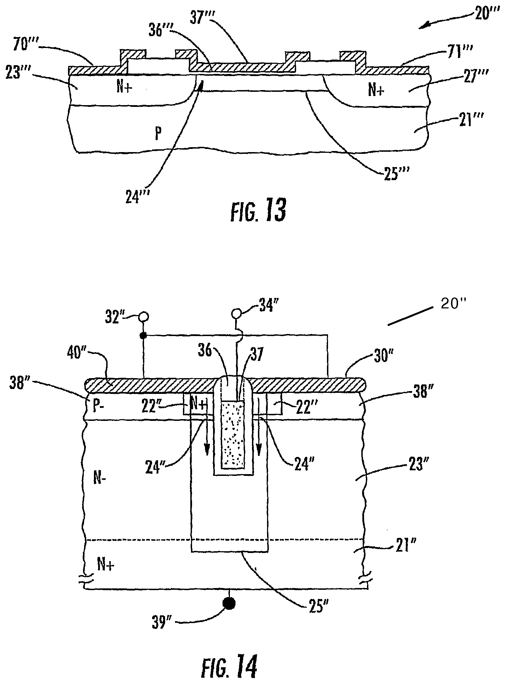

Using the above-described measures, one can select materials having improved band structures for specific purposes. One such example would be a superlattice 25 material (which will be discussed in further detail below) used in a metal-oxide semiconductor field-effect transistor (MOSFET), such as a lateral DMOS device 20 shown in FIGS. 1-4. While a lateral DMOS structure is shown and described herein for exemplary purposes, it will be appreciated that the superlattice material may also be similarly incorporated in other semiconductor devices (e.g., PMOS, NMOS, CMOS, etc.), as shown in FIG. 13. The device 20 illustratively includes a substrate 21, a source region 23, a body region 26, and a doped drain contact region 27. The source region 23 and the drain define a channel region 24 therebweteen, the channel region extending into the body region. The source and drain regions 23, 27 have respective contacts 70, 71 and metalizations 72, 73 thereon (FIG. 1). It will be understood that in FIG. 1 carrier flow would be from left to right. It should be noted that the drain of the illustrated device includes not only the doped drain region **27** (which is where an ohmic contact is made), but also portions of the N-type region to the right of, and below the P-type body **26**.

The device **20** also illustratively includes a plurality of spaced apart superlattices **25,** which in the present example extend into the channel and drain regions **24, 27.** The superlattices **25** illustratively extend laterally between the source and drain regions **23, 27.** In the illustrated embodiment the superlattices 25 are present in both the channel region **24** and the drain region **27.**

A gate structure **35** is formed on the substrate **21** and illustratively includes a gate dielectric layer **36** overlying the channel region **24,** and a gate electrode layer **37** overlying the gate dielectric layer. As will be appreciated from the description of the superlattice structures below, inclusion of the spaced-apart superlattices in the channel and drain regions **24, 27** of the device **20** may advantageously decrease on-resistance in the primary carrier flow path, which in the illustrated example is lateral and along the surface of the substrate **21,** since this is a lateral DMOSFET device. Also, in the illustrated example, the spaced apart superlattices **25** are substantially parallel to one another, although other configurations may be used in other embodiments.

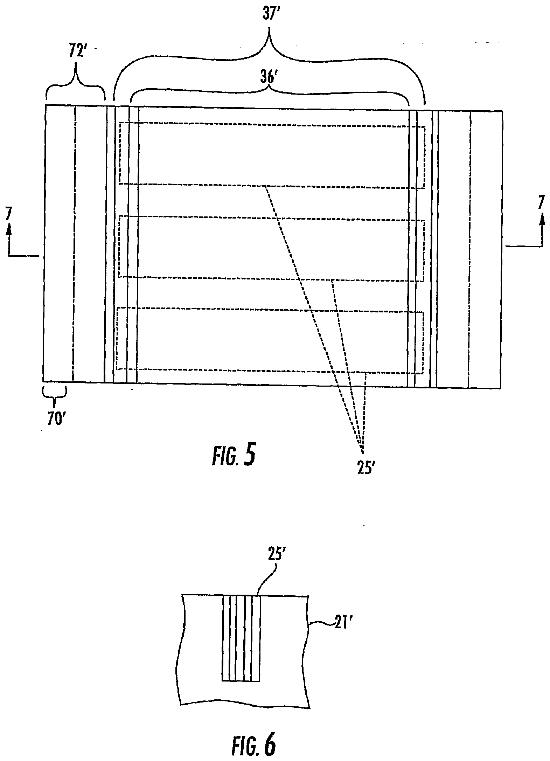

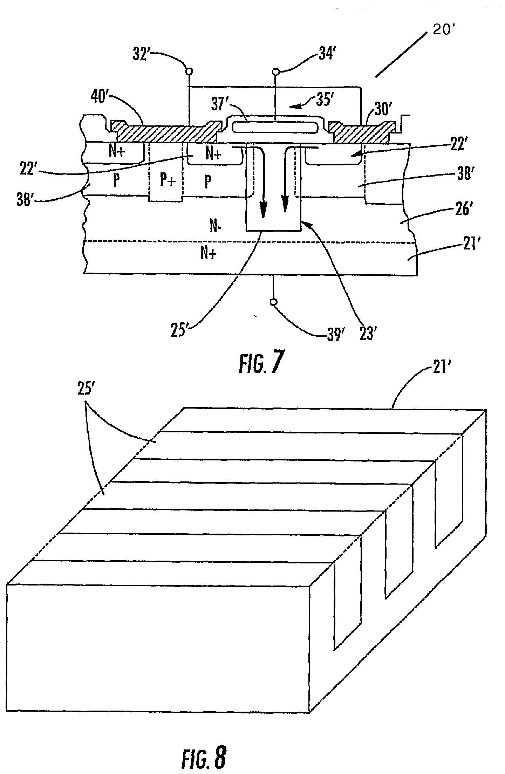

Turning now to FIGS. 5-8, another exemplary embodiment of a vertical DMOS device **20'** is now described. In this embodiment, the source region 22' and the drain 21', 26' both laterally are vertically spaced apart, i.e., the drain region is beside and below the source region with a body region **38'** positioned therebetween, and the superlattices **25'** extend vertically between the source and drain regions as seen in FIGS. 6 and 7. The body regions **38'** are formed in an N-epitaxial layer **26'** formed on N+ substrate **21'.** The device **20'** further illustratively includes metal contacts **30', 40'** adjacent to the gate **35',** a source/body terminal **32',** a gate terminal **34',** and a drain terminal **39'.**

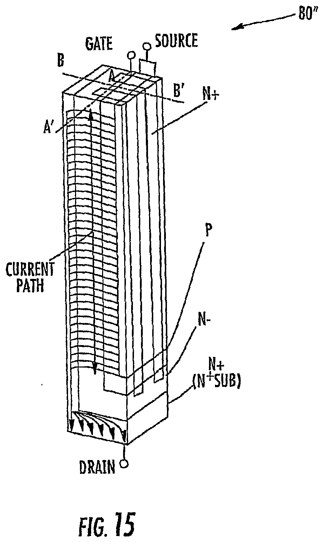

Here again, it should be noted that other device configurations are possible, such as a trench DMOS device **20"** shown in FIG. 14. Further details on trench DMOS devices may be found in U.S. Patent No. 4,767,722 to Blanchard. Another exemplary structure in which the above-described superlattice-filled trenches may advantageously be used to reduce device on-resistance is a super 3D MOSFET **80"** as shown in FIG. 15 and further described in an article by J. Sakakibara entitled "BreakThrough Of The Si Limit Under 300 V Breakdown Voltage With New Concept Power Device: Super 3D MOSFET," 2002 IEEE, Super 3D MOSFET, Proc. ISPSD, pgs. 233-236.

While all of the devices in the figures are n-channel devices, p-channel devices may be formed by substituting n-type regions for p-type regions and visa-versa.

The superlattices **25** may be formed using various techniques. One approach is to etch trenches in the substrate **21,** and then perform selective atomic layer deposition on the sidewalls and bottoms of the trenches (FIG. 2), or just the sidewalls of the trenches (FIG. 6) to form superlattice structures as described below, as will be appreciated by those skilled in the art. The trenches may extend just between the source and drain regions as shown in FIG. 1 and just between the source regions as shown in FIG. 5, or may extend across the entire device or across the entire wafer. Alternatively, superlattice **25** pillars may be formed on the surface of a semiconductor layer, and then semiconductor material may be deposited (e.g., epitaxially) or built-up on the semiconductor layer around the pillars and optionally polished to thereby define the substrate **21** with superlattices **25** therein. Further details regarding superlattice pillar formation may be found in co-pending U.S. Patent Application US 2006/0292889 A1 entitled FINFET INCLUDING A SUPERLATTICE to Mears et al., which is assigned to the current Assignee.

In the above-described devices, the inclusion of high mobility, band-engineered semiconductor superlattices **25** adjacent the drain region between the body-to-drain junction and the drain contact region may advantageously provide desired on-resistance reduction, as will be appreciated by those skilled in the art from the following description. The superlattices **25** may extend into the body of the source region in some embodiments, as will also be appreciated by those skilled in the art. The substrate **21** and the band-engineered semiconductor superlattices **25** will preferably have a resistivity that is high enough to withstand the desired device voltage.

Applicants have identified improved materials or structures for semiconductor devices such as MOSFETs, for example. More specifically, the Applicants have identified materials or structures having energy band structures for which the appropriate conductivity effective masses for electrons and/or holes are substantially less than the corresponding values for silicon.

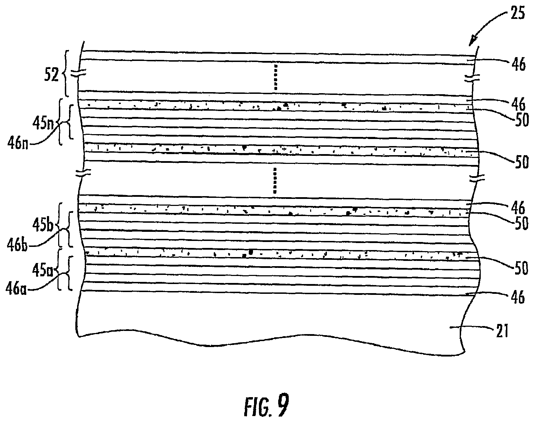

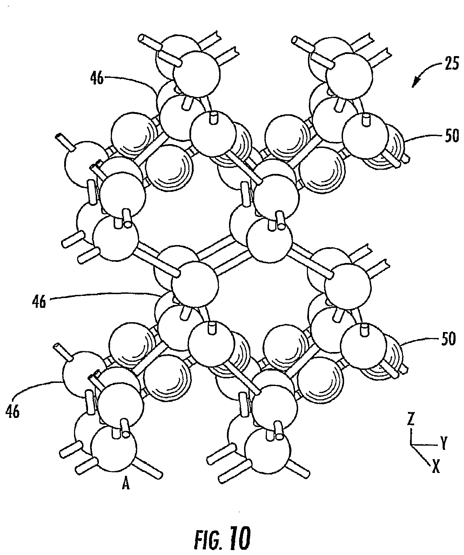

Referring now additionally to FIGS. 9 and 10, the materials or structures are in the form of a superlattice **25** whose structure is controlled at the atomic or molecular level and may be formed using known techniques of atomic or molecular layer deposition. The superlattice **25** includes a plurality of layer groups **45a-45n** arranged in stacked relation, as perhaps best understood with specific reference to the schematic cross-sectional view of FIG. 9.

Each group of layers **45a-45n** of the superlattice **25** illustratively includes a plurality of stacked base semiconductor monolayers **46** defining a respective base semiconductor portion **46a-46n** and an energy band-modifying layer **50** thereon. The energy band-modifying layers **50** are indicated by stippling in FIG. 1 for clarity of illustration.

The energy band-modifying layer **50** illustratively includes one non-semiconductor monolayer constrained within a crystal lattice of adjacent base semiconductor portions. In other embodiments, more than one such monolayer may be possible. It should be noted that reference herein to a non-semiconductor or semiconductor monolayer means that the material used for the monolayer would be a non-semiconductor or semiconductor if formed in bulk. That is, a single monolayer of a material, such as semiconductor, may not necessarily exhibit the same properties that it would if formed in bulk or in a relatively thick layer, as will be appreciated by those skilled in the art.

Applicants theorize without wishing to be bound thereto that energy band-modifying layers **50** and adjacent base semiconductor portions **46a-46n** cause the superlattice **25** to have a lower appropriate conductivity effective mass for the charge carriers in the parallel layer direction than would otherwise be present. Considered another way, this parallel direction is orthogonal to the stacking direction. The band-modifying layers **50** may also cause the superlattice **25** to have a common energy band structure. The band modifying layers **50** may also cause the superlattice **25** to have a common energy band structure, while also advantageously functioning as an insulator between layers or regions vertically above and below the superlattice.

Moreover, this structure may also advantageously act as a barrier to dopant and/or material bleed between layers vertically above and below the superlattice **25**. These properties may thus advantageously allow the superlattice **25** to provide an interface for high-K dielectrics which not only reduces bleeding of the high-K material into the channel region, but which may also advantageously reduce unwanted scattering effects and improve device mobility, as will be appreciated by those skilled in the art.

It is also theorized that semiconductor devices including the superlattice **25** may enjoy a higher charge carrier mobility based upon the lower conductivity effective mass than would otherwise be present. In some embodiments, and as a result of the band engineering achieved by the present invention, the superlattice **25** may further have a substantially direct energy bandgap that may be particularly advantageous for opto-electronic devices, for example, as described in further detail below.

The superlattice **25** also illustratively includes a cap layer **52** on an upper layer group **45n.** The cap layer **52** may comprise a plurality of base semiconductor monolayers **46**. The cap layer **52** may have between 2 to 100 monolayers of the base semiconductor, and, more preferably between 10 to 50 monolayers.

Each base semiconductor portion **46a-46n** may comprise a base semiconductor selected from the group consisting of Group IV semiconductors, Group III-V semiconductors, and Group II-VI semiconductors. Of course, the term Group IV semiconductors also includes Group IV-IV semiconductors, as will be appreciated by those skilled in the art. More particularly, the base semiconductor may comprise at least one of silicon and germanium, for example.

Each energy band-modifying layer **50** may comprise a non-semiconductor selected from the group consisting of oxygen, nitrogen, fluorine, and carbon-oxygen, for example. The non-semiconductor is also desirably thermally stable through deposition of a next layer to thereby facilitate manufacturing. In other embodiments, the non-semiconductor may be another inorganic or organic element or compound that is compatible with the given semiconductor processing as will be appreciated by those skilled in the art. More particularly, the base semiconductor may comprise at least one of silicon and germanium, for example

It should be noted that the term monolayer is meant to include a single atomic layer and also a single molecular layer. It is also noted that the energy band-modifying layer **50** provided by a single monolayer is also meant to include a monolayer wherein not all of the possible sites are occupied. For example, with particular reference to the atomic diagram of FIG. 10, a 4/1 repeating structure is illustrated for silicon as the base semiconductor material, and oxygen as the energy band-modifying material. Only half of the possible sites for oxygen are occupied.

In other embodiments and/or with different materials this one half occupation would not necessarily be the case as will be appreciated by those skilled in the art. Indeed it can be seen even in this schematic diagram, that individual atoms of oxygen in a given monolayer are not precisely aligned along a flat plane as will also be appreciated by those of skill in the art of atomic deposition. By way of example, a preferred occupation range is from about one-eighth to one-half of the possible oxygen sites being full, although other numbers may be used in certain embodiments.

Silicon and oxygen are currently widely used in conventional semiconductor processing, and, hence, manufacturers will be readily able to use these materials as described herein. Atomic or monolayer deposition is also now widely used. Accordingly, semiconductor devices incorporating the superlattice **25** in accordance with the invention may be readily adopted and implemented, as will be appreciated by those skilled in the art.

It is theorized without Applicants wishing to be bound thereto, that for a superlattice, such as the Si/O superlattice, for example, that the number of silicon monolayers should desirably be seven or less so that the energy band of the superlattice is common or relatively uniform throughout to achieve the desired advantages. The 4/1 repeating structure shown in FIGS. 9 and 10, for Si/O has been modeled to indicate an enhanced mobility for electrons and holes in the X direction. For example, the calculated conductivity effective mass for electrons (isotropic for bulk silicon) is 0.26 and for the 4/1 SiO superlattice in the X direction it is 0.12 resulting in a ratio of 0.46. Similarly, the calculation for holes yields values of 0.36 for bulk silicon and 0.16 for the 4/1 Si/O superlattice resulting in a ratio of 0.44.

While such a directionally preferential feature may be desired in certain semiconductor devices, other devices may benefit from a more uniform increase in mobility in any direction parallel to the groups of layers. It may also be beneficial to have an increased mobility for both electrons or holes, or just one of these types of charge carriers as will be appreciated by those skilled in the art.

The lower conductivity effective mass for the 4/1 Si/O embodiment of the superlattice **25** may be less than two-thirds the conductivity effective mass than would otherwise occur, and this applies for both electrons and holes. Of course, the superlattice **25** may further comprise at least one type of conductivity dopant therein, as will also be appreciated by those skilled in the art.

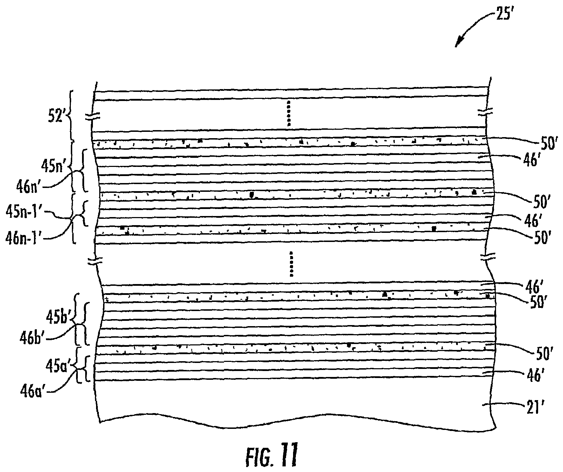

Indeed, referring now additionally to FIG. 11, another embodiment of a superlattice **25'** in accordance with the invention having different properties is now described. In this embodiment, a repeating pattern of 3/1/5/1 is illustrated. More particularly, the lowest base semiconductor portion **46a'** has three monolayers, and the second lowest base semiconductor portion **46b'** has five monolayers. This pattern repeats throughout the superlattice **25'**. The energy band-modifying layers **50'** may each include a single monolayer. For such a superlattice **25'** including Si/O, the enhancement of charge carrier mobility is independent of orientation in the plane of the layers. Those other elements of FIG. 11 not specifically mentioned are similar to those discussed above with reference to FIG. 9 and need no further discussion herein.

In some device embodiments, all of the base semiconductor portions of a superlattice may be a same number of monolayers thick. In other embodiments, at least some of the base semiconductor portions may be a different number of monolayers thick. In still other embodiments, all of the base semiconductor portions may be a different number of monolayers thick.

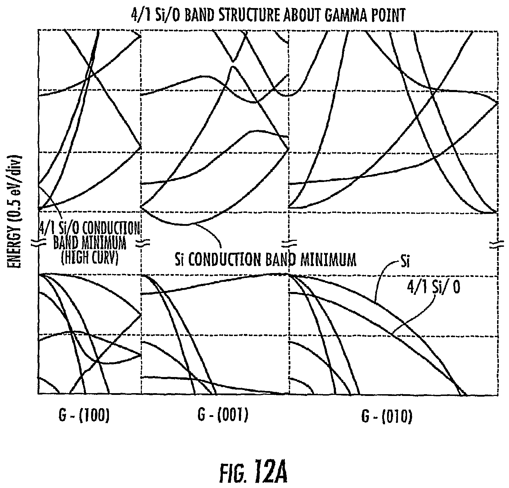

In FIGS. 12A-12C, band structures calculated using Density Functional Theory (DFT) are presented. It is well known in the art that DFT underestimates the absolute value of the bandgap. Hence all bands above the gap may be shifted by an appropriate "scissors correction." However the shape of the band is known to be much more reliable. The vertical energy axes should be interpreted in this light.

FIG. 12A shows the calculated band structure from the gamma point (G) for both bulk silicon (represented by continuous lines) and for the 4/1 Si/O superlattice **25** shown in FIG. 9 (represented by dotted lines). The directions refer to the unit cell of the 4/1 Si/O structure and not to the conventional unit cell of Si, although the (001) direction in the figure does correspond to the (001) direction of the conventional unit cell of Si, and, hence, shows the expected location of the Si conduction band minimum. The (100) and (010) directions in the figure correspond to the (110) and (-110) directions of the conventional Si unit cell. Those skilled in the art will appreciate that the bands of Si on the figure are folded to represent them on the appropriate reciprocal lattice directions for the 4/1 Si/O structure.

It can be seen that the conduction band minimum for the 4/1 Si/O structure is located at the gamma point in contrast to bulk silicon (Si), whereas the valence band minimum occurs at the edge of the Brillouin zone in the (001) direction which we refer to as the Z point. One may also note the greater curvature of the conduction band minimum for the 4/1 Si/O structure compared to the curvature of the conduction band minimum for Si owing to the band splitting due to the perturbation introduced by the additional oxygen layer.

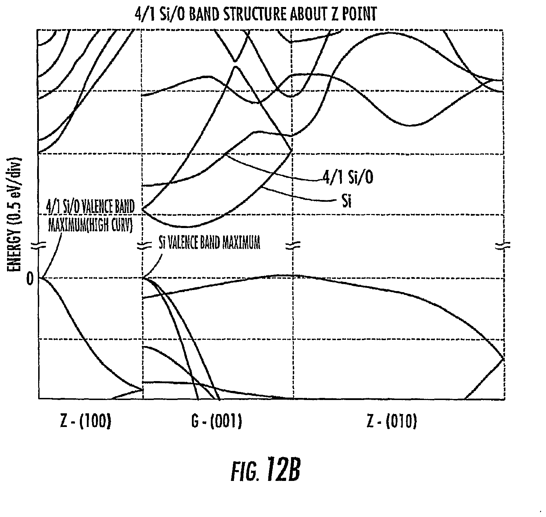

FIG. 12B shows the calculated band structure from the Z point for both bulk silicon (continuous lines) and for the 4/1 Si/O superlattice **25** (dotted lines). This figure illustrates the enhanced curvature of the valence band in the (100) direction.

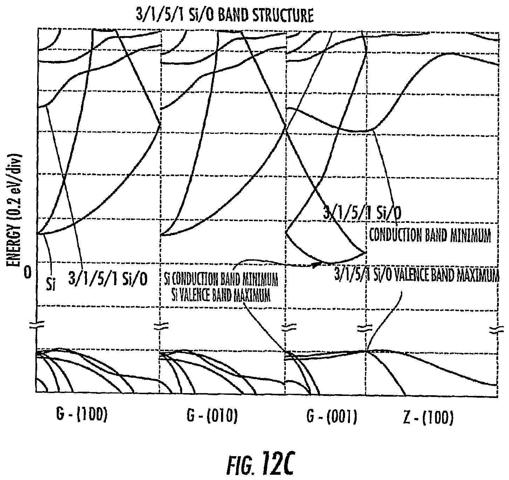

FIG. 12C shows the calculated band structure from both the gamma and Z point for both bulk silicon (continuous lines) and for the 5/1/3/1 Si/O structure of the superlattice **25'** of FIG. 11 (dotted lines). Due to the symmetry of the 5/1/3/1 Si/O structure, the calculated band structures in the (100) and (010) directions are equivalent. Thus the conductivity effective mass and mobility are expected to be isotropic in the plane parallel to the layers, i.e. perpendicular to the (001) stacking direction. Note that in the 5/1/3/1 Si/O example the conduction band minimum and the valence band maximum are both at or close to the Z point.

Although increased curvature is an indication of reduced effective mass, the appropriate comparison and discrimination may be made via the conductivity reciprocal effective mass tensor calculation. This leads Applicants to further theorize that the 5/1/3/1 superlattice **25'** should be substantially direct bandgap. As will be understood by those skilled in the art, the appropriate matrix element for optical transition is another indicator of the distinction between direct and indirect bandgap behavior.

Many modifications and other embodiments of the invention will come to the mind of one skilled in the art having the benefit of the teachings presented in the foregoing descriptions and the associated drawings. Therefore, it is understood that the invention is not to be limited to the specific embodiments disclosed, and that modifications and embodiments are intended to be included within the scope of the invention as defined by the appended claims.

**Claims**

1. A semiconductor device (20; 20'; 20") comprising:

   a substrate;
   a source region (23; 22'; 22") and a drain (21, 27; 21', 26'; 21", 23") comprising a drain region (21; 26'; 23") and a drain contact region (27; 21'; 21"), the source and the drain regions being spaced apart from one another and defining a channel region (24; 24'; 24") therebetween in said substrate; the source region being formed in a body region (26; 38'; 38") formed in the drain region, the channel region being located in the body region; said substrate having a plurality of spaced apart superlattices (25; 25'; 25") in the drain region, said plurality of superlattices extending into the channel region; each superlattice comprising a plurality of stacked groups of layers with each group comprising a plurality of stacked base semiconductor monolayers (46) defining a base semiconductor portion (46a-46n) and at least one non-semiconductor monolayer (50) thereon, and with the at least one non-semiconductor monolayer being constrained within a crystal lattice of adjacent base semiconductor portions and the layers of each superlattice being stacked so that charge carriers flow between the source and drain regions in a direction orthogonal to the stacking direction of the layers.

2. The semiconductor device (20) of Claim 1 wherein said source region (23) and said drain contact region (27) are laterally spaced apart.

3. The semiconductor device (20'; 20") of Claim 1 wherein said source region (22'; 22") and said drain contact region (21'; 21") are vertically spaced apart.

4. The semiconductor device (20) of Claim 1 wherein said spaced apart superlattices (25) extend laterally between said source region (23) and said drain contact region (27).

5. The semiconductor device (20'; 20") of Claim 1 wherein said spaced apart superlattices (25'; 25") extend vertically between said source region (22'; 22') and said drain contact region (21'; 21").

6. The semiconductor device (20; 20'; 20") of Claim 1 wherein said spaced apart superlattices (25; 25'; 25") are substantially parallel to one another.

7. The semiconductor device (20; 20'; 20") of Claim 1 further comprising a gate dielectric layer (36) adjacent the channel region (24), and a gate electrode layer (37; 37') adjacent said gate dielectric layer.

8. The semiconductor device (20; 20'; 20") of Claim 1 wherein each base semiconductor portion (46a-46n) comprises a base semiconductor selected from the group consisting of Group IV semiconductors, Group III-V semiconductors, and Group II-VI semiconductors; and wherein each non-semiconductor monolayer (50) comprises a non-semiconductor selected from the group consisting of oxygen, nitrogen, fluorine, and carbon-oxygen.

9. The semiconductor device (20; 20'; 20") of Claim 1 wherein opposing base semiconductor portions in adjacent groups of layers of each superlattice (25; 25'; 25") are chemically bound together.

10. A method for making a semiconductor device (20; 20'; 20") comprising:

providing a substrate having a plurality of spaced apart superlattices (25; 25'; 25") therein;
the device comprising a source region (23; 22'; 22") and a drain (21, 27; 26', 21'; 23", 21") comprising a drain region (21; 26'; 23") and a drain contact region (27; 21'; 21"), the source and the drain regions being spaced apart from one another and defining a channel region (24; 24'; 24") therebetween in said substrate; the source region being formed in a body region (26; 38'; 38") formed in the drain region, the channel being located in the body region; the spaced apart superlattices (25; 25'; 25") being in the drain region and extending into the channel region; each superlattice comprising a plurality of stacked groups of layers with each group comprising a plurality of stacked base semiconductor monolayers (46) defining a base semiconductor portion (46a-46n)and at least one non-semiconductor monolayer thereon, and with the at least one non-semiconductor monolayer (50) being constrained within a crystal lattice of adjacent base semiconductor portions, and the layers of each superlattice being stacked so that charge carriers flow between the source and drain regions in a direction orthogonal to the stacking direction of the layers.

11. The method of Claim 10 wherein the source region (23) and the drain contact region (27) are laterally spaced apart.

12. The method of Claim 10 wherein the source region (22'; 22") and the drain contact region (21'; 21") are vertically spaced apart.

13. The method of Claim 10 wherein each base semiconductor portion (46a-46n) comprises a base semiconductor selected from the group consisting of Group IV semiconductors, Group III-V semiconductors, and Group II-VI semiconductors; and wherein each non-semiconductor monolayer (50) comprises a non-semiconductor selected from the group consisting of oxygen, nitrogen, fluorine, and carbon-oxygen.

**Patentansprüche**

1.  Halbleitervorrichtung (20; 20'; 20"), die Folgendes umfasst:

    ein Substrat;
    eine Source-Region (23; 22'; 22") und einen Drain (21, 27; 21', 26'; 21", 23"), der eine Drain-Region (21; 26'; 23") und eine Drain-Kontaktregion (27; 21'; 21") umfasst, wobei die Source- und die Drain-Region voneinander beabstandet sind und eine Kanalregion (24; 24; 24") dazwischen in dem Substrat definieren;
    wobei die Source-Region in einer Körperregion (26; 38'; 38") ausgebildet ist, die in der Drain-Region ausgebildet ist, wobei sich die Kanalregion in der Körperregion befindet;
    wobei das Substrat mehrere voneinander beabstandete Übergitter (25; 25'; 25") in der Drain-Region aufweist, wobei sich die mehreren Übergitter in der Kanalregion erstrecken;
    wobei jedes Übergitter mehrere übereinander angeordnete Gruppen von Schichten umfasst, wobei jede Gruppe mehrere übereinander angeordnete Basishalbleiter-Monoschichten (46), die einen Basishalbleiterabschnitt (46a-46n) definieren, und mindestens eine Nicht-Halbleiter-Monoschicht (50) darauf umfasst, und wobei die mindestens eine Nicht-Halbleiter-Monoschicht innerhalb eines Kristallgitters aus benachbarten Basishalbleiterabschnitten beschränkt ist und die Schichten jedes Übergitters so übereinander angeordnet sind, dass Ladungsträger zwischen der Source- und der Drain-Region in einer Richtung orthogonal zur Stapelrichtung der Schichten fließen.

2.  Halbleitervorrichtung (20) nach Anspruch 1, wobei die Source-Region (23) und die Drain-Kontaktregion (27) lateral voneinander beabstandet sind.

3.  Halbleitervorrichtung (20'; 20") nach Anspruch 1, wobei die Source-Region (22'; 22") und die Drain-Kontaktregion (21'; 21") vertikal voneinander beabstandet sind.

4.  Halbleitervorrichtung (20) nach Anspruch 1, wobei sich die voneinander beabstandeten Übergitter (25) lateral zwischen der Source-Region (23) und der Drain-Kontaktregion (27) erstrecken.

5.  Halbleitervorrichtung (20'; 20") nach Anspruch 1, wobei sich die voneinander beabstandeten Übergitter (25'; 25") vertikal zwischen der Source-Region (22'; 22') und der Drain-Kontaktregion (21'; 21") erstrecken.

6.  Halbleitervorrichtung (20; 20'; 20") nach Anspruch 1, wobei die voneinander beabstandeten Übergitter (25; 25'; 25") im Wesentlichen parallel zueinander verlaufen.

7.  Halbleitervorrichtung (20; 20'; 20") nach Anspruch 1, die des Weiteren eine Gate-Dielektrikum-Schicht (36) neben der Kanalregion (24) und eine Gate-Elektrodenschicht (37; 37') neben der Gate-Dielektrikum-Schicht umfasst.

8.  Halbleitervorrichtung (20; 20'; 20") nach Anspruch 1, wobei jeder Basishalbleiterabschnitt (46a-46n) einen Basishalbleiter umfasst, der aus der Gruppe bestehend aus Gruppe-IV-Halbleitern, Gruppe-III-V-Halbleitern und Gruppe-II-VI-Halbleitern ausgewählt ist; und wobei jede Nicht-Halbleiter-Monoschicht (50) einen Nicht-Halbleiter umfasst, der aus der Gruppe bestehend aus Sauerstoff, Stickstoff, Fluor und Kohlenstoff-Sauerstoff ausgewählt ist.

9.  Halbleitervorrichtung (20; 20'; 20") nach Anspruch 1, wobei gegenüberliegende Basishalbleiterabschnitte in benachbarten Gruppen von Schichten jedes Übergitters (25; 25'; 25") chemisch aneinander gebunden sind.

10. Verfahren zum Herstellen einer Halbleitervorrichtung (20; 20'; 20"), das Folgendes umfasst:

    Bereitstellen eines Substrats, in dem sich mehrere voneinander beabstandete Übergitter (25; 25'; 25") befinden; wobei die Vorrichtung eine Source-Region (23; 22'; 22") und einen Drain (21, 27; 26', 21'; 23", 21") umfasst, der eine Drain-Region (21; 26'; 23") und eine Drain-Kontaktregion (27; 21'; 21") umfasst, wobei die Source- und die Drain-Region voneinander beabstandet sind und eine Kanalregion (24; 24'; 24") dazwischen in dem Substrat definieren; wobei die Source-Region in einer Körperregion (26; 38'; 38") ausgebildet ist, die in der Drain-Region ausgebildet ist, wobei sich der Kanal in der Körperregion befindet; wobei sich die voneinander beabstandeten Übergitter (25; 25'; 25") in der Drain-Region befinden und sich in die Kanalregion hinein erstrecken;

wobei jedes Übergitter mehrere übereinander angeordnete Gruppen von Schichten umfasst, wobei jede Gruppe mehrere übereinander angeordnete Basishalbleiter-Monoschichten (46), die einen Basishalbleiterabschnitt (46a-46n) definieren, und mindestens eine Nicht-Halbleiter-Monoschicht (50) darauf umfasst, und wobei die mindestens eine Nicht-Halbleiter-Monoschicht innerhalb eines Kristallgitters aus benachbarten Basishalbleiterabschnitten beschränkt ist und die Schichten jedes Übergitters so übereinander angeordnet sind, dass Ladungsträger zwischen der Source- und der Drain-Region in einer Richtung orthogonal zur Stapelrichtung der Schichten fließen.

**11.** Verfahren nach Anspruch 10, wobei die Source-Region (23) und die Drain-Kontaktregion (27) lateral voneinander beabstandet sind.

**12.** Verfahren nach Anspruch 10, wobei die Source-Region (22'; 22") und die Drain-Kontaktregion (21'; 21") vertikal voneinander beabstandet sind.

**13.** Verfahren nach Anspruch 10, wobei jeder Basishalbleiterabschnitt (46a-46n) einen Basishalbleiter umfasst, der aus der Gruppe bestehend aus Gruppe-IV-Halbleitern, Gruppe-III-V-Halbleitern und Gruppe-II-VI-Halbleitern ausgewählt ist; und wobei jede Nicht-Halbleiter-Monoschicht (50) einen Nicht-Halbleiter umfasst, der aus der Gruppe bestehend aus Sauerstoff, Stickstoff, Fluor und Kohlenstoff-Sauerstoff ausgewählt ist.

**Revendications**

**1.** Dispositif à semiconducteurs (20 ; 20' ; 20"), comprenant :

un substrat ;
une région de source (23 ; 22' ; 22") et un drain (21, 27 ; 21', 26' ; 21", 23") comprenant une région de drain (21 ; 26' ; 23") et une région de contact de drain (27 ; 21' ; 21"), les régions de source et de drain étant espacées l'une de l'autre et définissant une région de canal (24 ; 24' ; 24") entre celles-ci dans ledit substrat ;
la région de source étant formée dans une région de corps (26 ; 38' ; 38") formée dans la région de drain, la région de canal étant située dans la région de corps ;
ledit substrat comportant une pluralité de super-réseaux mutuellement espacés (25 ; 25' ; 25") dans la région de drain, ladite pluralité de super-réseaux s'étendant dans la région de canal ;
chaque super-réseau comprenant une pluralité de groupes de couches empilés, chaque groupe comprenant une pluralité de monocouches semiconductrices de base empilées (46) définissant une partie semiconductrice de base (46a à 46n) et au moins une monocouche non semiconductrice (50) sur celles-ci, et la monocouche non semiconductrice au nombre d'au moins une étant contrainte à l'intérieur d'un réseau cristallin de parties semiconductrices de base voisines, et les couches de chaque super-réseau étant empilées de telle sorte que des porteurs de charge circulent entre les régions de source et de drain dans une direction orthogonale à la direction d'empilement des couches.

**2.** Dispositif à semiconducteurs (20) selon la revendication 1, dans lequel ladite région de source (23) et ladite région de contact de drain (27) sont espacées latéralement.

**3.** Dispositif à semiconducteurs (20' ; 20") selon la revendication 1, dans lequel ladite région de source (22' ; 22") et ladite région de contact de drain (21' ; 21") sont espacées verticalement.

**4.** Dispositif à semiconducteurs (20) selon la revendication 1, dans lequel lesdits super-réseaux espacés (25) s'étendent latéralement entre ladite région de source (23) et ladite région de contact de drain (27).

**5.** Dispositif à semiconducteurs (20' ; 20") selon la revendication 1, dans lequel lesdits super-réseaux espacés (25' ; 25") s'étendent verticalement entre ladite région de source (22' ; 22") et ladite région de contact de drain (21' ; 21").

**6.** Dispositif à semiconducteurs (20 ; 20' ; 20") selon la revendication 1, dans lequel lesdits super-réseaux mutuellement espacés (25 ; 25' ; 25") sont sensiblement parallèles entre eux.

**7.** Dispositif à semiconducteurs (20 ; 20' ; 20") selon la revendication 1, comprenant de plus une couche de diélectrique de grille (36) adjacent à la région de canal (24), et une couche d'électrode de grille (37 ; 37') adjacent à ladite couche de diélectrique de grille.

**8.** Dispositif à semiconducteurs (20 ; 20' ; 20") selon la revendication 1, dans lequel chaque partie semiconductrice de base (46a à 46n) comprend un semiconducteur de base sélectionné parmi le groupe comprenant des semiconducteurs du groupe IV, des semiconducteurs du groupe III-V, et des semiconducteurs du groupe II-VI ; et dans lequel chaque monocouche non semiconductrice (50) comprend un non semiconducteur sélectionné parmi le groupe comprenant l'oxygène, l'azote, le fluor et le carbone-oxygène.

**9.** Dispositif à semiconducteurs (20 ; 20' ; 20") selon la revendication 1, dans lequel des parties semiconductrices de base opposées dans des groupes de couches adjacents de chaque super-réseau (25 ; 25' ; 25") sont chimiquement liées entre elles.

**10.** Procédé pour réaliser un dispositif à semiconducteurs (20 ; 20' ; 20"), comprenant :

la fourniture d'un substrat comportant une pluralité de super-réseaux espacés (25 ; 25' ; 25") à l'intérieur de celui-ci ;
le dispositif comprenant une région de source (23 ; 22' ; 22") et un drain (21, 27 ; 26', 21' ; 23", 21") comprenant une région de drain (21 ; 26' ; 23") et une région de contact de drain (27 ; 21' ; 21"), les régions de source et de drain étant espacées l'une de l'autre et définissant une région de canal (24 ; 24' ; 24") entre celles-ci dans ledit substrat ; la région de source étant formée dans une région de corps (26 ; 38' ; 38") formée dans la région de drain, le canal étant situé dans la région de corps ; les super-réseaux espacés (25 ; 25' ; 25") se trouvant dans la région de drain et s'étendant dans la région de canal ;
chaque super-réseau comprenant une pluralité de groupes de couches empilés, chaque groupe comprenant une pluralité de monocouches semiconductrices de base empilées (46) définissant une partie semiconductrice de base (46a à 46n) et au moins une monocouche non semiconductrice sur celles-ci, et la monocouche non semiconductrice au nombre d'au moins une (50) étant contrainte à l'intérieur d'un réseau cristallin de parties semiconductrices de base voisines, et les couches de chaque super-réseau étant empilées de telle sorte que des porteurs de charge circulent entre les régions de source et de drain dans une direction orthogonale à la direction d'empilement des couches.

**11.** Procédé selon la revendication 10, dans lequel la région de source (23) et la région de contact de drain (27) sont espacées latéralement.

**12.** Procédé selon la revendication 10, dans lequel la région de source (22' ; 22") et la région de contact de drain (21' ; 21") sont espacées verticalement.

**13.** Procédé selon la revendication 10, dans lequel chaque partie semiconductrice de base (46a à 46n) comprend un semiconducteur de base sélectionné parmi le groupe comprenant des semiconducteurs du groupe IV, des semiconducteurs du groupe III-V, et des semiconducteurs du groupe II-VI ; et dans lequel chaque monocouche non semiconductrice (50) comprend un non semiconducteur sélectionné parmi le groupe comprenant l'oxygène, l'azote, le fluor et le carbone-oxygène.

FIG. 1

FIG. 2

FIG. 3

FIG. 4

FIG. 5

FIG. 6

FIG. 7

FIG. 8

FIG. 9

FIG. 10

FIG. 11

4/1 Si/O BAND STRUCTURE ABOUT GAMMA POINT

FIG. 12A

4/1 Si/O BAND STRUCTURE ABOUT Z POINT

FIG. *12B*

FIG. 12C

FIG. 13

FIG. 14

FIG. 15

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20030057416 A, Currie
- US 20030034529 A, Fitzgerald
- US 6472685 B2, Takagi
- US 4937204 A, Ishibashi
- US 5357119 A, Wang
- US 5683934 A, Candelaria

- US 5216262 A, Tsu
- WO 02103767 A1, Wang, Tsu and Lofgren
- GB 2347520 A, Mears
- WO 2005034245 A
- US 4767722 A, Blanchard
- US 20060292889 A1

**Non-patent literature cited in the description**

- **TSU.** Phenomena in silicon nanostructure devices. *Applied Physics and Materials Science & Processing,* 06 September 2000, 391-402
- **LUO et al.** Chemical Design of Direct-Gap Light-Emitting Silicon. *Physical Review Letters,* 12 August 2002, vol. 89 (7

- BreakThrough Of The Si Limit Under 300 V Breakdown Voltage With New Concept Power Device: Super 3D MOSFET. **J. SAKAKIBARA.** Super 3D MOSFET, Proc. ISPSD. IEEE, 2002, 233-236